# EUROPEAN PATENT SPECIFICATION

(11) **EP 2 348 800 B1**
(45) Date of publication and mention of the grant of the patent: **12.03.2014**
(21) Application number: 10000775.6
(22) Date of filing: 26.01.2010
(51) Int. Cl.: H02J 1/10, H05K 7/14

(54) **Redundant power supply device**
Redundante Stromversorgungsvorrichtung
Dispositif d'alimentation électrique redondant

(43) Date of publication of application: 27.07.2011
(73) Proprietor: Portwell Inc., Shulin City, 23845 Taipei County (TW)
(72) Inventor: Yang, Shang-Sheng, Shulin City 23845 Taipei County (TW)
(74) Representative: Zeitler, Giselher

(56) References cited:
- EP-A2- 1 052 759
- US-A- 3 699 394
- US-A- 5 982 619
- US-A- 6 038 126
- US-B1- 6 421 215
- US-B2- 6 390 831

## Description

### BACKGROUND OF THE INVENTION

### 1. Field of the Invention

The present invention relates to a redundant power supply system, and more particularly to a redundant power supply system without installing a heat dissipating fan, and the power supply system comes with a swappable AC or DC power input, operates together with an external input power supply, and provides a convenient modular installation.

### 2. Description of the Related Art

As the design of a redundant power supply module device available in the present power supply market generally comes with a redundant application of N + 1 power supply devices and uses a plurality of hot swappable power supply devices to achieve the aforementioned function. If any one of the power supply devices in the redundant power supply module fails, a backup power supply device can take over the power supply function to prevent errors occurred during the operation of a computer system due to a power failure, and the defective power supply device is hot swappable without the need of turning off a computer system.

However, the redundant power supply devices of this sort can be applied as a single-mode external input power supply such as an AC input or a DC input only. Since the power input comes with a fixed mode and cannot be switched, therefore it is necessary to manufacture two separate redundant power supply devices for both the AC and DC inputs, and the conventional power supply devices incur higher manufacturing cost and management cost. Obviously, the conventional redundant power supply devices require improvements.

Some electronic components installed in the power supply device may be overheated during their operation. As the using time increases and the heat cannot be eliminated effectively, the normal operation of the power supply device will be affected and thus the heat dissipation issue becomes important. Although present existing single power supply devices or redundant power supply devices come with the design of a heat dissipating fan for adjusting the temperature of the power supply devices or redundant power supply devices, yet the effect is not significant or effective sometimes, particularly for a long time of use. Besides the production of noises, the conventional power supply devices also fails to achieve the effect of lowering the temperature to a predetermined temperature. Furthermore, the use of the heat dissipating fan increases the volume of the power supply device and consumes additional electric power. In the power supply device having a chassis with a smaller size specification (such as the specification having height*width*depth equal to 150mm*86mm*N mm, +10mm; wherein N is a depth without any specific limitation), the present existing redundant power supply devices can accommodate 1+1 power supply devices only. If it is necessary to provide an output of 3+1 (or more) power supply devices, another chassis will be required to accommodate extra power supply devices, and the volume efficiency cannot be improved effectively.

In view of the shortcomings of the prior art, the inventor of the present invention based on years of experience in the related industry to conduct extensive researches and experiments, and finally developed a modular swappable redundant power supply device with the advantages of power input interchangeability, modular convenience, effective increased volume efficiency and better heat dissipation without the need of installing a heat dissipating fan to overcome the shortcomings of the prior art.

US 6,421,215 B1 discloses a server system for telecommunication application, which includes within a chassis, a large number of different electric and electronic subsystems. One of those subsystems is a power sub-assembly which includes a power sub-frame with a power distribution board and three accommodation spaces for three power supply units. The power supply units are identical and provide redundant power for the server system. Each of the power supply units supplies all of the different electric tensions and signals needed to operate the different electric and electronic subsystems of the server system.

EP 1 052 759 A2 discloses a duplexed power supply system having a secondary DC outputting circuit B, which is primarily powered by an AC power circuit A. In case the AC power circuit A fails, the secondary DC outputting circuit B is powered by a battery powered DC power circuit C.

### Summary of the Invention

Therefore, it is a primary object of the present invention to overcome the aforementioned shortcoming and deficiency of the prior art by providing a redundant power supply system in accordance with the present invention, such that an external power input has the function of a modular assembling and provides a swappable and interchangeable application to achieve the advantages of flexible manufacturing, assembling and application, so as to enhance the economic benefits and product competitiveness.

Another object of the present invention is to reduce the volume of the redundant power supply system effectively, such that the chassis of the redundant power supply system with a smaller size specification (such as the specification having height*width*depth equal to 150mm*86mm*N mm, +10mm, wherein N is a longitudinal depth with any specific limitation) can provide an output of 3 or more power supply systems to meet the connection requirements of various different electric devices selectively.

A further object of the present invention is to provide a redundant power supply system with modular package and high heat dissipation, such that the chassis or the power supply system can have an excellent heat dissipating efficiency without the need of installing a heat dissipating fan to assure the function and safety of the application.

To achieve the foregoing object, the present invention provides a redundant power supply system comprising the features of claim 1.

Further embodiments are mentioned in the subclaims.

The invention also provides a method of adapting such a redundant power supply system comprising the features of claim 13.

The aforementioned and other objects and technical characteristics of the present invention will become apparent with the detailed description of the preferred embodiments and the illustration of related drawings as follows.

### BRIEF DESCRIPTION OF THE DRAWINGS

FIG. 1 is a perspective front view of a first preferred embodiment of the present invention;
FIG. 2 is a perspective rear view of a first preferred embodiment of the present invention;
FIG. 3 is an exploded view of a first preferred embodiment of the present invention;
FIG. 4 is an exploded view of a heat dissipation design of a power supply system of the present invention;
FIG. 5 is a cross-sectional view of a heat dissipation design of a power supply system of the present invention;
FIG. 6 is a schematic view of a second preferred embodiment of the present invention;
FIG. 7 is a schematic view of electrically coupling a redundant power supply system of the present invention; and
FIG. 8 is a schematic view of a third preferred embodiment of the present invention.

### DETAILED DESCRIPTION OF THE PREFERRED EMBODIMENTS

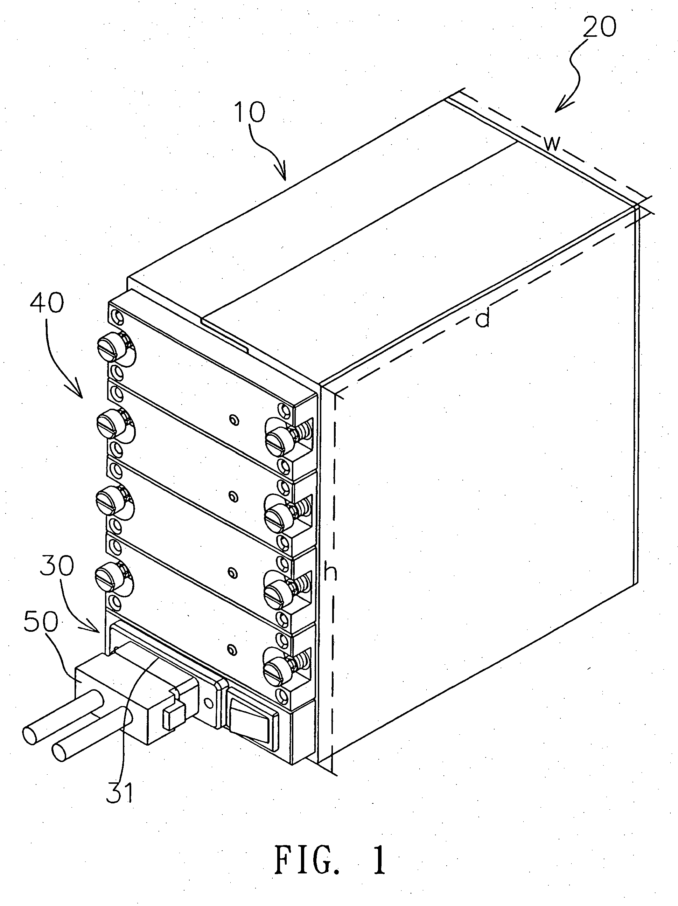

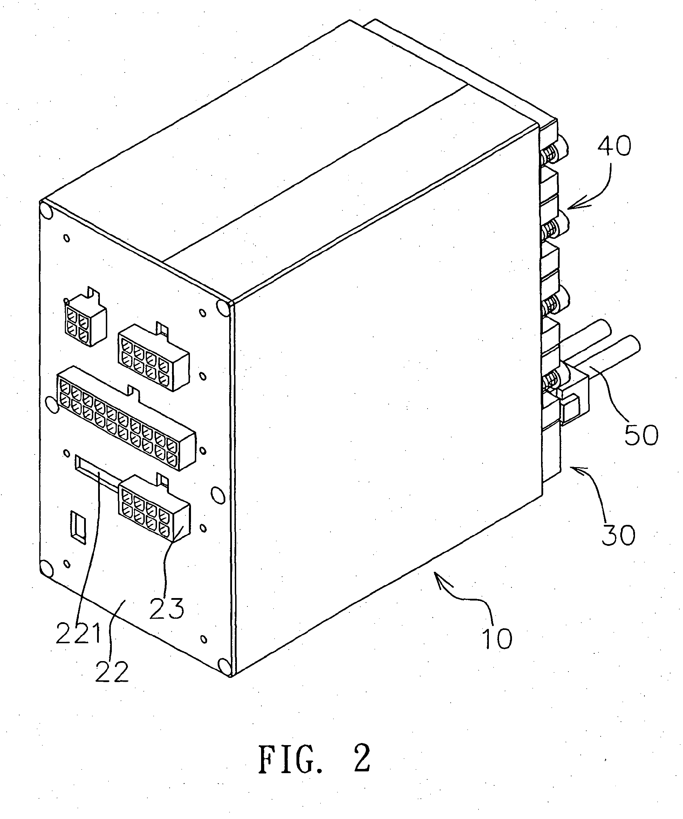

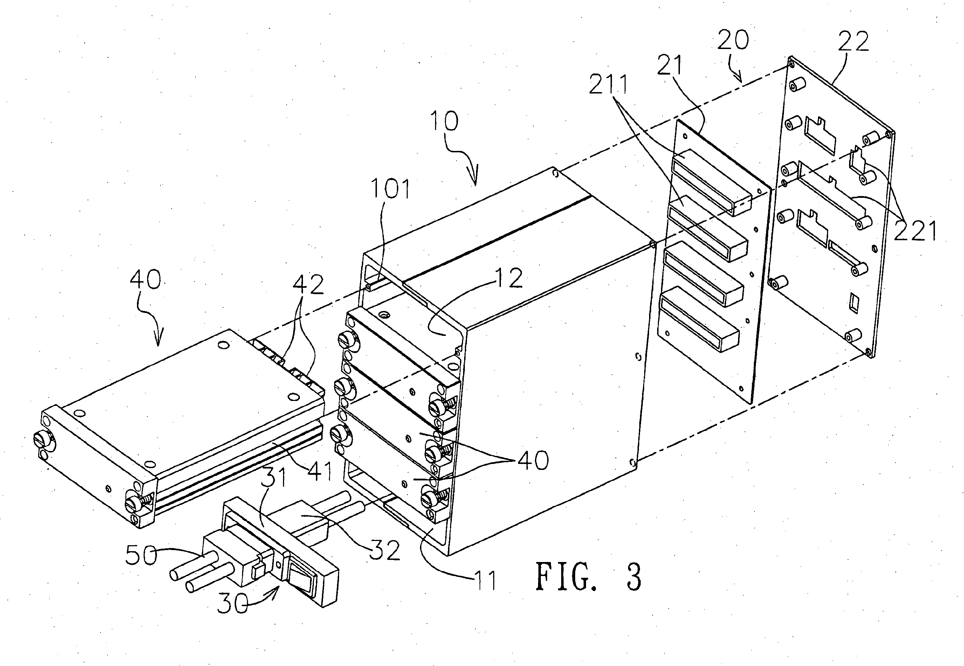

With reference to FIGS. 1 to 3 for a redundant power supply system in accordance with a first preferred embodiment of the present invention, the redundant power supply system, particularly the one without installing a heat dissipating fan, comprises a chassis 10, a back panel device 20, a power input module 30 and a plurality of power supply devices 40.

The chassis 10 includes a containing space formed therein and partitioned into a power input accommodating space 11 and a plurality of power output accommodating spaces 12 (wherein there are 3+1 power output accommodating spaces 12 in this preferred embodiment), and rails 101 disposed on both sides of the chassis 10 and corresponding to the containing spaces (and the size specification of the chassis having height (h)*width (w)*depth (d) is equal to 150mm*86mm*N mm, +10mm in this preferred embodiment, wherein N is a longitudinal depth without any specific limitation).

The back panel device 20 comprises a back panel 21 and an output board 22, and the back panel 21 (such as a printed circuit board) is mounted onto the chassis 10 (or at the rear of the chassis in this preferred embodiment), and the back panel 21 includes a plurality of back panel connectors 211 installed on a side opposite to the chassis 10, and each back panel connector 211 corresponds to each power input accommodating space 11 of the chassis 10 (or the power output accommodating space 12), and the output board 22 is fixed to the back panel 21, and the output board 22 includes a plurality of electric connector slots 221 with various different specifications, and a plurality of electric output connectors 23 corresponding to the plurality of electric connector slots 221 for installing different external electric devices respectively, wherein the electric output connector 23 and the back panel 21 are electrically connected to the corresponding back panel connectors 211. In other words, the output board 22 includes a plurality of various electric output connectors 23 for selectively and conveniently connecting various different electric devices.

The power input module 30 is installed in the power input accommodating space 11 of the chassis 10 (wherein there is one power input module in this preferred embodiment) for providing the function of converting an external AC (such as 110V or 220V) into DC or an external DC (such as 5V ∼ 76V) into DC, and the power input module 30 includes a power input conversion circuit 31 and a transmission port 32, and the power input conversion circuit 31 is provided for connecting a power port 50 (which is an external current input source), and the transmission port 32 is electrically connected to the back panel device 20 (or the back panel 21).

If the power port 50 is an AC input port, the power input conversion circuit 31 converts AC into DC to be inputted to the back panel; and if the power port 50 is a DC input port, it is necessary to switch the power input conversion circuit 31 to the DC-to-DC conversion circuit to input the converted DC to the back panel. In other words, the power input of the power input module 30 can be installed in the power input accommodating space 11 with an AC or DC power input module selectively according to the application requirement of an external AC or DC input to meet a user's requirement.

The plurality of power supply devices 40 (wherein there are 3+1 power supply devices in this preferred embodiment) can be respectively and swappably installed in the plurality of power output accommodating spaces 12 of the chassis 10, and the power supply device 40 includes a slide slot 41 disposed on a side of the power supply device 40, and a rail 101 of the power output accommodating space 12 can be installed slidably into the slide slot 41, and a power supply connector 42 is installed at a rear end of the power supply device 40 and connected to the back panel connector 211.

Since the external power input of the conventional redundant power supply device is fixed and limited to a selective use of AC and DC power inputs, the power input module 30 of the present invention is modularized, and the back panel 21 can be shared, therefore a system with only one power supply device is needed, and the AC or DC of the power input module 30 is installed selectively and swappably to allow users to choose the use of a DC input or an AC input. Such arrangement not only provides a more flexible application to the product, but also simplifies the components and lowers the cost of the product.

In addition, the redundant power supply system of the present invention further comprises an electric output connector 23 installed on the back panel 21 to provide a convenient external connection, and the present invention comes with a flexible modular design, a shared back panel, and a selective use of the electric output connector 23, the present invention provides a modular design with an output DC power supply of 3.3V, 5V, +12V, 5VSB for a flexible and convenient application to meet the requirements of connecting different electric devices.

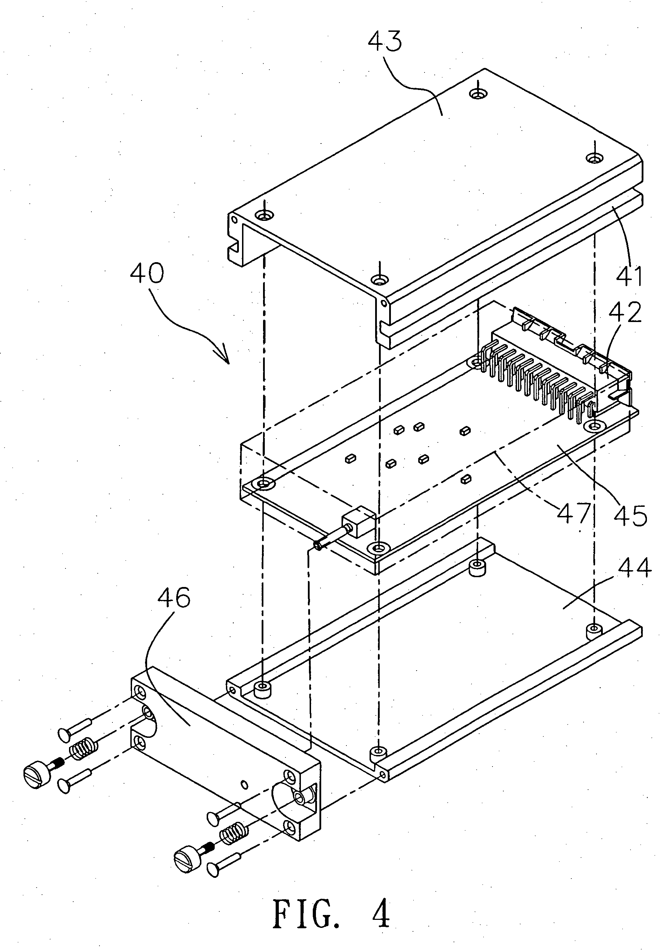

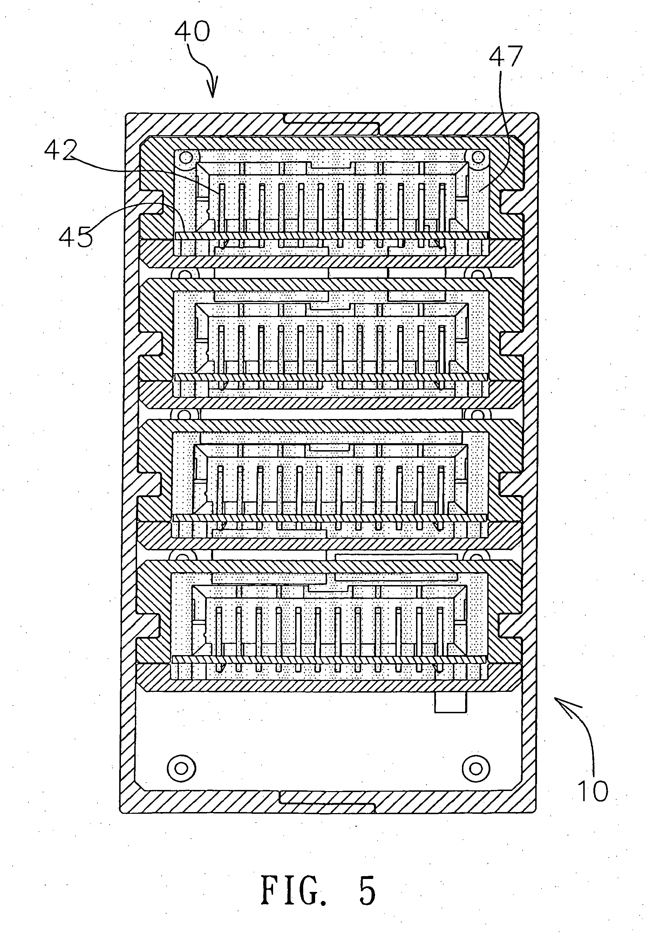

With reference to FIGS. 4 and 5, the power supply device 40 of the present invention further comprises an upper casing 43, a lower casing 44, a modular printed circuit board 45 and a front panel 46, wherein the modular printed circuit board 45 includes related electronic component installed thereon and the power supply connector 42 installed at the rear of the modular printed circuit board 45, and the modular printed circuit board 45 and its electronic components (including the power supply connector 42) are packaged by a thermal conductive glue 47, and the thermal conductive glue 47 is attached closely with the upper casing 43, the lower casing 44 and the front panel 46, such that the heat generated by the electronic components in the power supply device 40 can be transmitted through the thermal conductive glue 47 to the upper casing 43, the lower casing 44 and the front panel 46 (which constitute the modular chassis) to enhance the heat dissipating efficiency substantially, so as to overcome the poor heat dissipation of the power supply without installing the heat dissipating fan and reducing the volume of the power supply device 40 effectively.

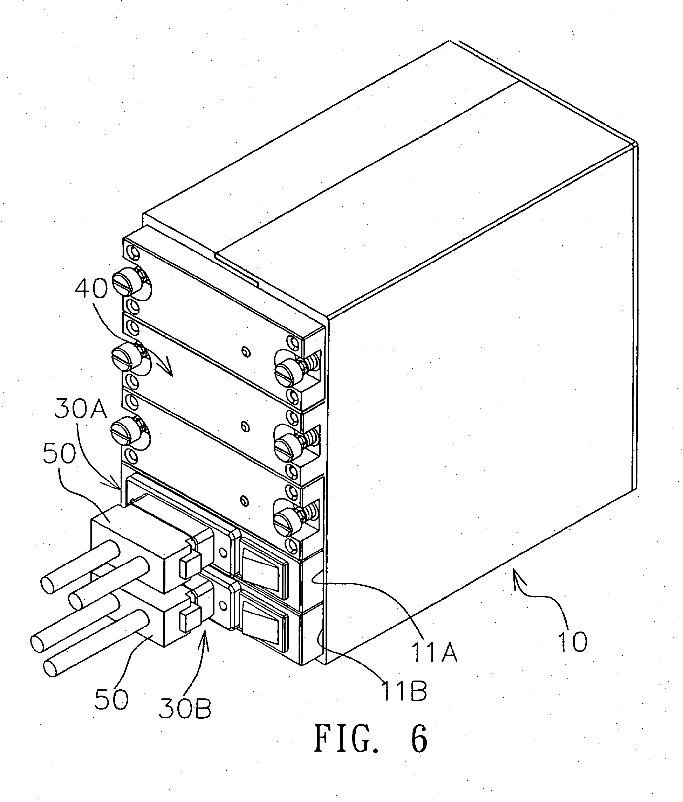

With reference to FIG. 6, the present invention redundant power supply device second preferred embodiment, this embodiment is based on the structural design of the first preferred embodiment and further comprises two power input modules 30A, 30B, which can be AC or DC input modules, and the chassis 10 includes two power input accommodating spaces 11A, 11B, such that the power input modules 30A, 30B can provide a modular redundant power input function to facilitate a steady supply of the power input. The number of power supply devices 40 in the chassis 10 with a smaller size specification (such as the specification having height*width*depth equal to 150mm*86mm*N mm, +10mm, wherein N is a longitudinal depth without any specific limitation) is equal to or less than 2+1.

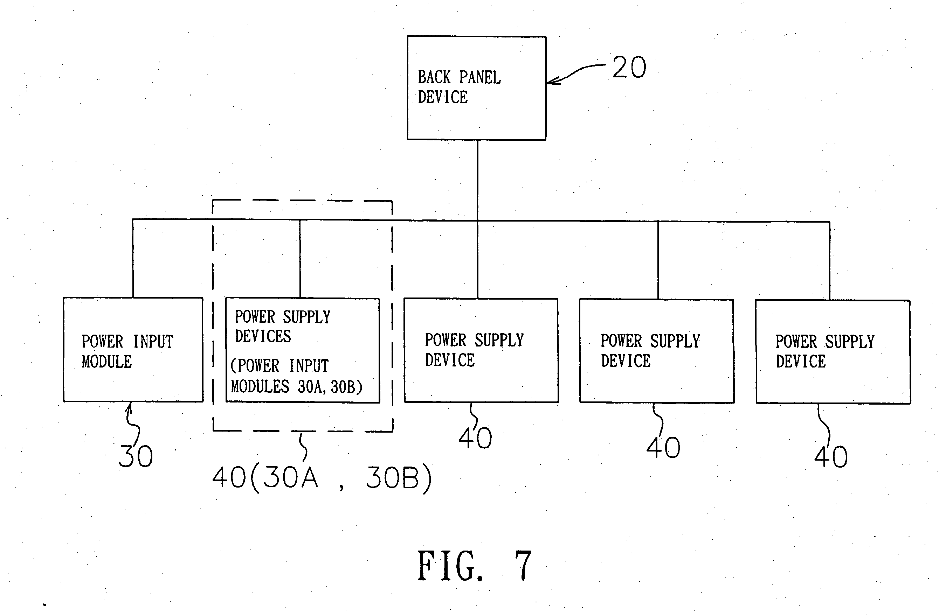

In the aforementioned structure, the redundant power supply systems of the present invention share one back panel 21 for an AC or DC input module. In FIG. 7, if the present invention has a power input module 30 (either DC or AC power input module), the power input module 30 is connected to the plurality of power supply devices 40 and jointly and electrically coupled to the back panel 21, and the back panel 21 is provided for the final power output. If there are two power input modules 30A, 30B (DC or AC power input modules) stacked with each other in the present invention, the power input modules 30A, 30B are electrically coupled to the plurality of power supply devices 40 and jointly and electrically coupled to the back panel 21, and the back panel 21 is provided for the final power output.

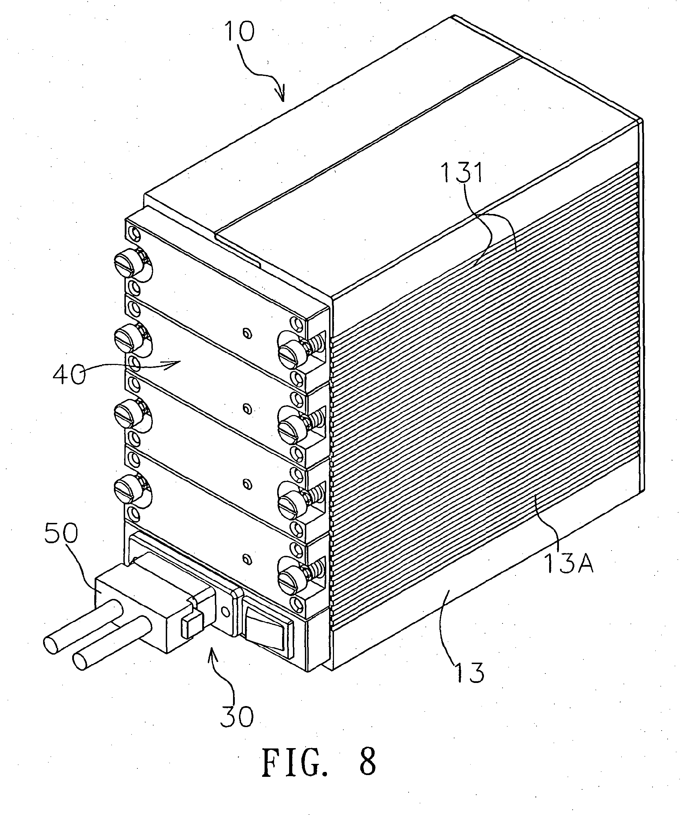

With reference to FIG. 8 for a redundant power supply system in accordance with a third preferred embodiment of the present invention, this embodiment is based on the structure of the first preferred embodiment and further comprises a heat sink 13A installed on the side panel 13 of the chassis 10, and the heat sink 13A includes wavy heat dissipating line grooves 131 formed thereon for improving the heat dissipating effect, while the chassis 10 is made of a metal material (such as an aluminum sheet) having a better heat dissipating performance, and the thermal conductive glue 47 of the present invention is used for attaching the modular printed circuit board 45 closely with the chassis 10 to maximize the thermal conducting efficiency of the present invention, so as to enhance the quality, safety and durability of the application.

In summation of the present invention having a modular power input/output design and a selective swappable application can provide flexible manufacturing, assembling and application to achieve better economic effects and product competitiveness, and the power output can be selected to meet the requirements of connecting various different electric devices for different applications. In addition, the present invention comes with a modular package and a good heat dissipation effect, and thus the heat dissipating efficiency is excellent to assure the quality and safety of using the power supply device.

Obviously, the present invention enhances the prior art and complies with patent application requirements, and thus is duly filed for the patent application.

While the invention has been described by device of specific embodiments, numerous modifications and variations could be made thereto by those generally skilled in the art.The scope of the invention is set forth in the claims.

## Claims

1. A redundant power supply system, comprising;
- a chassis (10), having at least one power input accommodating space (11) and a plurality of power output accommodating spaces (12), and the chassis (10) having a height and a width equal to 150+10mm and 86+10mm respectively;
- a back panel device (20), including a back panel (21), which is a printed circuit board, and the back panel (21) being mounted onto the chassis (10) and having a plurality of back panel connectors (211) disposed on the back panel (21) and at position opposite to the accommodating spaces (11, 12) respectively; wherein the back panel device (20) further includes an output board (22) fixed to the back panel (21), and the output board (22) includes a plurality of electric output connectors (23), electrically coupled to the back panel (21) or the corresponding back panel connectors (211);
- a plurality of power supply devices (40), each being installed in the power output accommodating spaces (12), and having a power supply connector (42) connecting to the back panel connectors (211);
- at least one first power input module (30) having a power input conversion circuit (31) for providing an external AC-to-DC conversion function and at least one second power input module (30) having a power input conversion circuit (31) for providing an external DC-to-DC conversion function, whereas the first power input module (30) and the second power input module (30) are selectively and swappably installable as a power input into the power input accommodating space (11) for electrically connecting to the plurality of power supply devices (40) and for jointly and electrically coupling to the back panel (21).

2. The redundant power supply system of claim 1, **characterized in that** the chassis (10) includes rails (101) disposed on sides of the accommodating spaces (11, 12) respectively, and corresponding slide slots (41) disposed on sides of the power supply devices (40) respectively.

3. The redundant power supply system of claim 1, **characterized in that** the plurality of electric output connectors (23) are passed through and installed to a plurality of electric connector slots (221) on the output board (22) respectively.

4. The redundant power supply system of claim 1, **characterized in that** the power supply device (40) further includes an upper casing (43), a lower casing (44) and a modular printed circuit board (45) integrally connected for installing the power supply connector (42), and the modular printed circuit board (45) includes related electronic components installed thereon, and the modular printed circuit board (45) is packaged by a thermal conductive glue (47).

5. The redundant power supply system of claim 4, **characterized in that** the thermal conductive glue (47) is attached closely with the upper casing (43) and the lower casing (44).

6. The redundant power supply system of claim 1, **characterized by** comprising two power input modules (30A, 30B), and the chassis (10) having two power input accommodating spaces (11A, 11 B), and the two power input modules (30A, 30B) being installed in the two power input accommodating spaces (11A, 11B) as a power input.

7. The redundant power supply system of claim 6, **characterized by** comprising 2+1 or less power supply devices (40), and the power supply devices (40) being installed swappably in the power output accommodating spaces (12) as a power input.

8. The redundant power supply system of claim 1, **characterized in that** the power input module (30) and the plurality of power supply devices (40) are electrically coupled to the back panel (21).

9. The redundant power supply system of claim 1, **characterized in that** the chassis (10) includes a side panel (13), a heat sink (13A) formed on the side panel (13), and wavy heat dissipating line grooves (131) formed on the heat sink (13A).

10. The redundant power supply system of claim 1, **characterized in that** the power input module (30) comes with a quantity of one, and the power supply devices (40) come with a quantity of less than 3+1.

11. The redundant power supply system of claim 1, **characterized in that** the external input DC power supply has a voltage of 5V~76V.

12. The redundant power supply system of claim 1, **characterized in that** the output DC power supply has a voltage of 3.3V, 5V, +12V or 5VSB.

13. A method of adapting a redundant power supply system according to one of the preceding claims to an application requirement of an external AC or DC input, **characterized in that** either the first power input module (30) or the second power input module (30) is selectively installed according to the application requirement without changing the back panel (21).

## Patentansprüche

1. Redundantes Stromversorgungssystem, umfassend ein Chassis (10) mit wenigstens einem Stromeingangs-Aufnahmeraum (11) und mehreren Stromausgangs-Aufnahmeräumen (12), wobei das Chassis (10) eine Höhe und eine Breite aufweist, die gleich 150 + 10 mm bzw. 86 + 10 mm betragen; ferner umfassend eine Rückplatten-Einrichtung (20) mit einer Rückplatte (21), die eine gedruckte Schaltungstafel ist und die auf dem Chassis (10) angebracht ist und mehrere Rückplattenanschlüsse (211) aufweist, die sich auf der Rückplatte (21) befinden sowie an den Aufnahmeräumen (11, 12) entsprechend gegenüberliegender Stelle, wobei die Rückplatten-Einrichtung (20) des weiteren mit einer Ausgangstafel (22) versehen ist, die mit der Rückplatte (21) verbunden ist und die mehrere elektrische Ausgangsanschlüsse (23) aufweist, welche elektrisch mit der Rückplatte (21) oder den entsprechenden Rückplattenanschlüssen (211) gekoppelt sind; des weiteren umfassend mehrere Stromversorgungs-Vorrichtungen (40), von denen jede in den Stromausgangs-Aufnahmeräumen (12) installiert ist und einen Stromzufuhranschluß (42) aufweist, der mit den Rückplattenanschlüssen (211) verbunden ist; und schließlich umfassend wenigstens einen Stromeingangsmodul (30), der einen Stromeingangswandler-Schaltkreis (31) zur Erzeugung einer externen Wechselstrom-zu-Gleichstrom-Umwandlung besitzt, und wenigstens einen zweiten Stromeingangsmodul (30), der einen Stromeingangswandler-Schaltkreis (31) aufweist, der zur Erzeugung einer Gleichstrom-zu-Gleichstrom-Umwandlung dient, wobei der erste Stromeingangsmodul (30) und der zweite Stromeingangsmodul (30) selektiv und wechselweise als Stromeingang in den Stromeingangs-Aufnahmeraum (11) installierbar sind, um die vielen Stromversorgungs-Einrichtungen elektrisch anzuschließen und dadurch sie im einzelnen und elektrisch mit der Rückwand (21) zu verbinden.

2. Redundantes Stromversorgungssystem nach Anspruch 1, **dadurch gekennzeichnet, daß** das Chassis (10) Schienen (101) aufweist, die auf den Seiten der Aufnahmeräume (11, 12) entsprechend angeordnet sind, und daß entsprechende Schlitze (41) auf den Seiten der Stromversorgungs-Einrichtungen (40) entsprechend liegen.

3. Redundantes Stromversorgungssystem nach Anspruch 1, **dadurch gekennzeichnet, daß** die Vielzahl der elektrischen Ausgangsverbindungen (23) durch mehrere elektrische Anschlußschlitze (221) geführt bzw. auf der Austragstafel (22) installiert sind.

4. Redundantes Stromversorgungssystem nach Anspruch 1, **dadurch gekennzeichnet, daß** die Stromversorgungs-Einrichtung (40) des weiteren ein oberes Gehäuse (43), ein unteres Gehäuse (44) und eine modulare, gedruckte Schaltungstafel (45) aufweist, die zum Zwecke der Installierung des Stromversorgungsanschlusses (42) integral verbunden sind, und daß die modulare gedruckte Schaltungstafel (45) entsprechende elektronische Komponenten aufweist, die auf ihr installiert sind, während die modulare gedruckte Schaltungstafel (45) durch einen thermischen, leitfähigen Kleber (47) angebracht ist.

5. Redundantes Stromversorgungssystem nach Anspruch 4, **dadurch gekennzeichnet, daß** der thermische, leitfähige Kleber (47) nahe an dem oberen Gehäuse (43) und dem unteren Gehäuse (44) angebracht ist.

6. Redundantes Stromversorgungssystem nach Anspruch 1, **dadurch gekennzeichnet, daß** es zwei Stromeingangsmodule (30A, 30B) aufweist und das Chassis (10) mit zwei Stromeingangs-Aufnahmeräumen (11A, 11 B) versehen ist, wobei die beiden Stromeingangsmodule (30A, 30B) in den zwei Stromeingangs-Aufnahmeräumen (11A, 11 B) als Stromeingang installiert sind.

7. Redundantes Stromversorgungssystem nach Anspruch 6, **dadurch gekennzeichnet, daß** es 2 + 1 oder weniger Stromversorgungs-Einrichtungen (40) aufweist und daß die Stromeingangs-Einrichtungen (40) in den Stromausgangs-Aufnahmeräumen (12) als Stromeingang wechselnd installiert werden.

8. Redundantes Stromversorgungssystem nach Anspruch 1, **dadurch gekennzeichnet, daß** der Stromeingangsmodul (30) und die vielen Stromversorgungs-Einrichtungen (40) elektrisch mit der Rückwand (21) gekoppelt sind.

9. Redundantes Stromversorgungssystem nach Anspruch 1, **dadurch gekennzeichnet, daß** das Chassis (10) eine Seitenplatte (13), eine auf der Seitenplatte (13) ausgebildete Wärmesenke (13A) sowie wellige Wärme abführende, linienförmige Nuten (131), die in der Wärmesenke (13A) ausgebildet sind, aufweist.

10. Redundantes Stromversorgungssystem nach Anspruch 1, **dadurch gekennzeichnet, daß** das Stromeingangsmodul (30) in einer Menge eins liefert, und die Stromversorgungs-Einrichtungen (40) in einer Menge von weniger 3 + 1 liefern.

11. Redundantes Stromversorgungssystem nach Anspruch 1, **dadurch gekennzeichnet, daß** die externe Stromeingangsversorgung eine Spannung von 5 V bis 76 V hat.

12. Redundantes Stromversorgungssystem nach Anspruch 1, **dadurch gekennzeichnet, daß** die Gleichstrom-Ausgangsquelle eine Spannung von 3,4 V, 5 V +12 V oder 5 VSB hat.

13. Verfahren zur Anpassung eines redundanten Stromversorgungssystems gemäß einem der vorhergehenden Ansprüche an ein Anwendungsforderung eines externen Wechselstrom- oder Gleichstromeingangs, **dadurch gekennzeichnet, daß** entweder der erste Stromeingangsmodul (30) oder der zweite Stromeingangsmodul (30) gemäß dem Anwendungserfordernis ohne Änderung der Rückwand (21) wahlweise installiert werden.

## Revendications

1. Système redondant d'alimentation de puissance, comprenant :
- un châssis (10) ayant au moins un espace de logement pour entrée de puissance (11) et une pluralité d'espaces de logement pour sortie de puissance (12), et le châssis (10) ayant une hauteur et une largeur égales à 150 + 10 mm et 86 + 10 mm respectivement ;
- un dispositif formant panneau arrière (20), incluant un panneau arrière (21), qui est une carte à circuits imprimés, et le panneau arrière (21) étant monté sur le châssis (10) et ayant une pluralité de connecteurs de panneau arrière (211) disposés sur le panneau arrière (21) et à une position à l'opposé des espaces de logement (11, 12) respectivement ; dans lequel le dispositif formant panneau arrière (20) inclut en outre une carte de sortie (22) fixée au panneau arrière (21), et la carte de sortie (22) inclut une pluralité de connecteurs de sortie électriques (23), couplés électriquement au panneau arrière (21) ou aux connecteurs de panneau arrière (211) correspondants ;
- une pluralité de dispositifs d'alimentation de puissance (40), chacun étant installé dans les espaces de logement de sortie de puissance (12), et ayant un connecteur d'alimentation de puissance (42) connecté aux connecteurs de panneau arrière (211) ;
- au moins un premier module d'entrée de puissance (30) ayant un circuit de conversion d'entrée de puissance (31) pour réaliser une fonction de conversion de courant alternatif/continu externe, et au moins un second module d'entrée de puissance (30) ayant un circuit de conversion d'entrée de puissance (31) pour réaliser une fonction de conversion de courant continu/continu externe, tandis que le premier module d'entrée de puissance (30) et le second module d'entrée de puissance (30) sont susceptibles d'être installés de manière sélective et interchangeable à titre d'entrée de puissance dans l'espace de logement d'entrée de puissance (11) pour être connectés électriquement à la pluralité de dispositifs d'alimentation de puissance (40) et pour être conjointement couplés électriquement au panneau arrière (21).

2. Système redondant d'alimentation de puissance selon la revendication 1, **caractérisé en ce que** le châssis (10) inclut des rails (100) disposés sur les côtés des espaces de logement (11, 12) respectivement, et des fentes latérales correspondantes (41) disposées sur des côtés des dispositifs d'alimentation de puissance (40) respectivement.

3. Système redondant d'alimentation de puissance selon la revendication 1, **caractérisé en ce que** la pluralité de connecteurs de sortie électriques (23) sont passés à travers et installés dans une pluralité de fentes pour connecteurs électriques (221) sur la carte de sortie (22) respectivement.

4. Système redondant d'alimentation de puissance selon la revendication 1, **caractérisé en ce que** le dispositif d'alimentation de puissance (40) inclut en outre un boîtier supérieur (43), un boîtier inférieur (44) et une carte à circuits imprimés modulaire (45) connectée intégralement pour installer le connecteur d'alimentation de puissance (42), et la carte à circuits imprimés modulaire (45) inclut des composants électroniques relatifs installés sur elle-même, et la carte à circuits imprimés modulaire (45) est enrobée par une colle thermoconductrice (47).

5. Système redondant d'alimentation de puissance selon la revendication 4, **caractérisé en ce que** la colle thermoconductrice (47) est attachée de manière intime avec le boîtier supérieur (43) et avec le boîtier inférieur (44).

6. Système redondant d'alimentation de puissance selon la revendication 1, **caractérisé en ce qu'**il comprend deux modules d'entrée de puissance (30A, 30B), et le châssis (10) comporte deux espaces de logement pour entrée de puissance (11A, 11 B), et les deux modules d'entrée de puissance (30A, 30B) sont installés, à titre d'entrée de puissance, dans les deux espaces de logement pour entrée de puissance (11A, 11 B).

7. Système redondant d'alimentation de puissance selon la revendication 6, **caractérisé en ce qu'**il comprend 2+1 dispositifs d'alimentation de puissance (40) ou moins, et les dispositifs d'alimentation de puissance (40) sont installés de manière interchangeable dans les espaces de logement pour sortie de puissance (12) à titre d'entrée de puissance.

8. Système redondant d'alimentation de puissance selon la revendication 1, **caractérisé en ce que** le module d'entrée de puissance (30) et la pluralité de dispositifs d'alimentation de puissance (40) sont couplés électriquement au panneau arrière (21).

9. Système redondant d'alimentation de puissance selon la revendication 1, **caractérisé en ce que** le châssis (10) inclut un panneau latéral (13), un puits thermique (13A) formé sur le panneau latéral (13), et des rainures linéaires ondulées de dissipation de chaleur (131) formées sur le puits thermique (13A).

10. Système redondant d'alimentation de puissance selon la revendication 1, **caractérisé en ce que** le module d'entrée de puissance (30) est prévu au nombre de un, et les dispositifs d'alimentation de puissance (40) sont prévus en nombre inférieur à 3+1.

11. Système redondant d'alimentation de puissance selon la revendication 1, **caractérisé en ce que** l'alimentation de puissance d'entrée externe en courant continu a un voltage de 5V à 76V.

12. Système redondant d'alimentation de puissance selon la revendication 1, **caractérisé en ce que** l'alimentation de puissance de sortie en courant continu a un voltage de 3,3V, 5V, + 12V ou 5VSB.

13. Procédé pour adapter un système redondant d'alimentation de puissance selon l'une quelconque des revendications précédentes à une application exigeant une entrée externe en courant alternatif ou en courant continu, **caractérisé en ce que** l'on installe sélectivement soit le premier module d'entrée de puissance (30) soit le second module d'entrée de puissance (30), en accord avec l'exigence de l'application sans changer le panneau arrière (21).
